# EUROPÄISCHE PATENTANMELDUNG

(11) **EP 4 844 397 A1**
(43) Veröffentlichungstag der Anmeldung: **25.11.2026**
(21) Anmeldenummer: 25178463.3
(22) Anmeldetag: 23.05.2025
(51) Int. Cl.: G01N 29/12, G01N 29/24

(54) **VERFAHREN UND ANORDNUNG ZUR FUNKTIONSPRÜFUNG EINER MINDESTENS EINES, INSBESONDERE IN EINER ELEKTRONISCHEN SCHALTUNG ANGEORDNETEN, ELEKTROLYTKONDENSATORS**

(71) Anmelder: Siemens Aktiengesellschaft, 80333 München (DE)
(72) Erfinder: Kriegel, Kai, 81739 München (DE); Mitic, Gerhard, 81827 München (DE); Raab, Oliver, 94496 Ortenburg (DE); Santos Wilke, Hans, 85599 Parsdorf (DE); Weisbrod, Erik, 81369 München (DE)
(74) Vertreter: Siemens Patent Attorneys

(57) **Zusammenfassung**

Die Erfindung betrifft ein Verfahren zur Funktionsprüfung einer mindestens eines, insbesondere in einer elektronischen Schaltung angeordneten, Elektrolytkatalysators, bei dem zu zumindest einem ersten Zeitpunkt auf Grundlage zumindest eines externen Anregungssignals erzeugte mechanische Anregung des Elektrolytkondensators zumindest eine, insbesondere Veränderung einer, mechanischen, mit dem Maß, insbesondere des Verlusts, des Elektrolyten korrelierenden, Eigenschaft des Elektrolytkondensators ermittelt wird. Ferner betrifft die Erfindung eine Anordnung zur Funktionsprüfung einer mindestens eines, insbesondere in einer elektronischen Schaltung angeordneten, Elektrolytkatalysators mit Mitteln zur Durchführung des Verfahrens.

## Beschreibung

Die Erfindung betrifft ein Verfahren zur Funktionsprüfung einer mindestens eines, insbesondere in einer elektronischen Schaltung angeordneten, Elektrolytkatalysators, gemäß dem Oberbegriff des Anspruchs 1 sowie eine Anordnung zur Funktionsprüfung einer mindestens eines, insbesondere in einer elektronischen Schaltung angeordneten, Elektrolytkatalysators, gemäß Oberbegriff des Anspruchs 14.

Elektrolytkondensatoren, insbesondere mit Flüssigelektrolyten, altern durch den Austritt des Elektrolyten. Dies geschieht durch Diffusion und ist typischerweise ein schleichender Prozess, welcher sich jedoch erst spät auch elektrisch durch einen Ausfall des Kondensators äußert. Dieser Prozess hängt u.a. von den Umgebungs- und Einsatzbedingungen ab. Liegt ein Defekt in der Ummantelung des Kondensators vor, kann dieser Prozess auch schnell ablaufen.

Kommen also Rückläufer ins Werk, wird die Baugruppe hinsichtlich möglicher Defekte, Recyclierbarkeit, Wiederverwertbarkeit untersucht. Elektrolytkondensatoren können insbesondere elektrisch vermessen werden und ein Defekt so erkannt werden.

Bei dieser elektrischen Prüfung werden die Kapazität, der Innenwiderstand oder der so genannte "Equivalent Series Resistance" ESR Wert (parasitärer Widerstand) und der sogenannte "Equivalent Series Inductance" ESL Wert (parasitäre Induktivität) des Kondensator bestimmt. Diese Werte geben indirekt Rückschlüsse auf einen möglichen Verlust des Elektrolyten. Sie sind womöglich jedoch erst nach einem bereits erheblichen Verlust und somit kurz vor einem Totalausfall messbar.

Ist jedoch bisher nur bis zu einem gewissen Grad Elektrolytflüssigkeit entwichen, so liegt unter Umständen noch kein Defekt vor, steht aber kurz bevor. Der Kondensator hat dann aber bereits an Kapazität verloren.

Diesem Nachteil wird dahingehend begegnet, dass der Austritt des Elektrolyten aus einem defekten Kondensator oder das Aufblähen eines Kondensators durch eine visuelle Kontrolle festgestellt werden.

Dies ist aber, insbesondere, wenn es durch Recyclingfachpersonen geprüft wird, zeitaufwendig und fehleranfällig, da Veränderungen übersehen werden können.

Die der Erfindung zugrundeliegende Aufgabe besteht darin eine technische Lösung anzugeben, die die Nachteile des Standes der Technik zu überwindet. Insbesondere besteht die Aufgabe darin eine akkurate Prüfung von Elektrolytkondensatoren zu ermöglichen.

Diese Aufgabe wird ausgehend von dem Verfahren zur Funktionsprüfung einer mindestens eines, insbesondere in einer elektronischen Schaltung angeordneten, Elektrolytkatalysators des Anspruchs 1, durch dessen kennzeichnende Merkmale, sowie ausgehend von der Anordnung zur Funktionsprüfung einer mindestens eines, insbesondere in einer elektronischen Schaltung angeordneten, Elektrolytkatalysators, gemäß Oberbegriff des Anspruch 14, durch dessen kennzeichnende Merkmale gelöst.

Bei dem erfindungsgemäßen Verfahren zur Funktionsprüfung einer mindestens eines, insbesondere in einer elektronischen Schaltung angeordneten, Elektrolytkatalysators, wird zu zumindest einem ersten Zeitpunkt auf Grundlage zumindest eines externen Anregungssignals erzeugte mechanische Anregung des Elektrolytkondensators zumindest eine, insbesondere Veränderung einer, mechanischen, mit dem Maß, insbesondere des Verlusts, des Elektrolyten korrelierenden, Eigenschaft des Elektrolytkondensators ermittelt.

Durch die Erfindung wird es möglich den Verlust des Elektrolyten eines oder mehrerer Elektrolytkondensatoren rechtzeitig zu ermitteln, denn hierdurch lässt sich ohne elektrische Messung zumindest akkurat angeben, ob ein Funktionsverlust des Elektrolytkondensators unmittelbar bevorsteht, und somit, insbesondere durch geeignete Weiterbildungen besonders akkurat, auch die Restlebensdauer des Elektrolytkondensators ermitteln, da beides unmittelbar durch den Verlust des Elektrolyten, welcher über die Zeit bei dieser Art elektronischem Bauteil gegeben ist, bzw. der noch vorhandenen Restmenge abhängt. Durch den erfindungsgemäßen Ansatz wird eine Lösung erzielt, die im Gegensatz zur Messung elektrischer Eigenschaften nicht nur die gegebene Funktion ermitteln kann, sondern auch, ob ein Funktionsverlust bald bevorsteht, so dass ein weiterer Einsatz des Elektrolytkondensators keinen Sinn mehr macht. Daher ist die Erfindung besonders vorteilhaft einsetzbar, wenn es um das Wiederverwenden von Bauteilen, beispielsweise aus einer ausgemusterten Baugruppe geht. Sie ist aber sicherlich auch bei Funktionsprüfungen, die beispielsweise im Rahmen von regelmäßigen Instandhaltungen von Baugruppen bzw. Geräten durchgeführt werden, vorteilhaft einsetzbar, da der Ausfall von Elektrolytkondensatoren verhindert werden kann, in dem zu diesem Zeitpunkt der baldige Funktionsverlust antizipiert wird. Das erfindungsgemäße Verfahren ist dabei so flexibel, dass es beispielsweise auch mehrere Elektrolytkondensatoren zur gleichen Zeit bewerten kann. Beispielsweise können die Kondensatoren gemeinsam in der Baugruppe verbaut oder auch lose gemessen werden, solange eine Anregung der Bauteile derart besteht, dass sie die Elektrolytkondensatoren mechanisch anregt, so dass hierdurch messbare physikalische Effekte an den Elektrolytkondensatoren erzeugt werden.

Daher umfasst die Erfindung in der allgemeinsten Form auch Implementierungen, bei der bereits eine gegebene Anregung, die zuverlässig und mit bekannter, insbesondere konstanter, Charakteristik vorhanden ist, beispielsweise der Transport einer den/die Elektrolytkondensator/-en transportierenden Band oder ähnliches, das Vibrationen erzeugt, genutzt werden, solange dies zu diesen geeigneten, messbaren physikalischen Effekten führt.

Durch die erfindungsgemäße Anordnung wird die Implementierung des Verfahrens strukturell realisiert und somit zur Umsetzung der Vorteile des Verfahrens und/oder seiner Weiterbildungen beigetragen.

Gemäß einer bevorzugten Weiterbildung des erfindungsgemäßen Verfahrens wird als externes Anregungssignal zumindest eine durch eine externe Ultraschallquelle erzeugte Schallwelle der Elektrolytkondensator zur Schwingung angeregt und zumindest vom Elektrolytkondensator reflektierte Anteile der Schallwelle korrelierende Parameter, insbesondere Eigenfrequenzen, Moden, Dämpfung zumindest einer Frequenz der reflektierten Anteile und/oder Schallgeschwindigkeit, derart erfasst werden, dass in Abhängigkeit der Parameter der Grad des Verlusts des Elektrolyten bestimmt wird.

Dies hat den Vorteil, dass die Ultraschallquelle als eine gezielte Anregung eingesetzt wird, deren Charakteristik und Auswirkung auf die zu prüfenden Kondensatoren zurückgeführt werden kann. Da die physikalischen Effekte ohne Vermittlung durch mechanisch erzeugte Schwingungen erfolgt, sondern über Schwingungen, ist dieser Ansatz verschleißarm durchführbar. Ferner verursacht eine derartige Anregung einen physikalischen Effekt auf die angeregten Kondensatoren, der vielerlei erfassbare Parameter bietet, die einzeln oder in Kombination eine akkurate Bestimmung des Verlusts des Elektrolyten ermöglichen.

Bei einer Weiterbildung des erfindungsgemäßen Verfahrens wird die Ultraschallquelle im so genannten Durchschallverfahren betrieben.

Dies ist eine gängige aus Einsätzen von Ultraschall in der Materialprüfung bekannte Verfahrensweise, so dass diese eine einfache Realisierung des Verfahrens bietet. Sender und Empfänger sind hier getrennt, so dass dies einen Freiheitsgrad hinsichtlich der Anordnung bietet, sollte dies nützlich oder erforderlich sein.

Eine weitere vorteilhafte Weiterbildung des erfindungsgemäßen Verfahrens ist gegeben, wenn alternativ oder ergänzend die Ultraschallquelle im so genannten Impuls-Echo Verfahren betrieben wird. Diese Weiterbildung zeichnet sich, insbesondere dadurch aus, dass Sender und Empfänger in einem Prüfkopf vereint sind und/oder sich desselben Piezoelements bedienen, was die Anordnung unter anderem kompakter macht.

Beide Weiterbildungen weisen zudem den Vorteil auf, dass durch sie der Effekt erkennbar wird, dass bei Verlust des Elektrolyten erfinderseitig erkannt wurde, dass sich über die Zeit die Laufzeit und Dämpfung reflektierter Anteile des Schalls verändert und mit dem erfindungsgemäßen Verfahren feststellbar ist.

Gemäß einer weiteren Weiterbildung des erfindungsgemäßen Verfahrens wird die zumindest eine Schallwelle derart erzeugt, dass ihre Frequenz in einem Bereich nahe der Eigenresonanzfrequenz des Elektrolytkondensators eingestellt wird, wobei als Parameter zumindest der Wert der Amplitude und/oder der Wert der Phase des reflektierten Anteils der Schwingung erfasst wird. Vorteilhaft ist die Ultraschallanregung in der Nähe einer Eigenresonanzfrequenz eines Elektrolytkondensators, da in diesem Fall große Änderungen von Amplitude und Phase zu erwarten sind, so dass eine hierauf basierende Bewertung der verbrauchten und/oder noch vorhandenen Menge an Elektrolyt im Kondensator zuverlässiger wird.

Dies kann vorteilhaft noch besser ausgenutzt werden, wenn das erfindungsgemäße Verfahren derart weitergebildet wird, dass eine Vielzahl an Schallwellen unterschiedlicher Frequenzen derart erzeugt werden, dass zumindest jeweils eine Frequenz der unterschiedlichen Frequenzen nahe jeweils einer Eigenresonanzfrequenz aus einer Vielzahl von Eigenfrequenzen derart eingestellt wird, dass zu jeder Eigenresonanzfrequenz der Vielzahl von Eigenresonanzfrequenzen zumindest eine Frequenz erzeugt wird.

Dies realisiert eine Einstrahlung von Ultraschallsignalen mit einer großen Bandbreite, die die Anregung gleich mehrerer Eigenresonanzen ermöglicht.

Hierdurch kann ein relativer Vergleich der reflektierten Amplituden unterschiedlicher Frequenzen (Eigenfrequenzen) ermöglicht werden, was weitere Möglichkeiten bei der Bewertung eines Elektrolytkondensators erlaubt.

Beispielswiese kann dies als Alterungsindikator genutzt werden, der weitgehend unabhängig von geometrischen Randbedingungen ist, insbesondere wenn das erfindungsgemäße Verfahren derart weitergebildet wird, dass für jede Frequenz die Parameter der reflektierten Anteile erfasst werden, wobei der Maß, insbesondere des Verlusts, des Elektrolyten anhand eines Vergleichs der Parameter je Frequenz ermittelt wird.

Als Indikator ist es vorteilhaft hierzu eine, insbesondere diskrete Anzahl an Frequenzen fest vorzugeben, welche direkt auf die Detektion von Feuchtigkeit (oder deren Abwesenheit) abziehen, wie dass gemäß der Weiterbildung des erfindungsgemäßen Verfahrens bei dem eine diskrete Anzahl von, insbesondere im kHz-Bereich und/oder MHz-Bereich eingestellten, Frequenzen innerhalb der Bandbreite festgelegt wird.

Alternativ oder ergänzend kann das erfindungsgemäße Verfahren auch diese und weitere Vorteile erzielen, wenn es derart weitergebildet wird, dass die Frequenzen innerhalb der Bandbreite derart eingestellt werden, dass sie innerhalb einer Zeitspanne ein durch Bandbreite bestimmtes Intervall von, insbesondere im kHz-Bereich und/oder MHz-Bereich eingestellten, Frequenzen durchlaufen.

Wird das erfindungsgemäße Verfahren derart weitergebildet, dass für die Ermittlung der mechanischen Eigenschaft des Elektrolytkondensators, insbesondere die Erfassung der Parameter der reflektierten Anteile, ein Laser-Doppler-Vibrometer betrieben wird, kann das unter anderem zu einer schnellen Vermessung ganzer Gruppen von Elektrolytkondensatoren führen. Hierdurch wird die Gruppe der Elkos extern angeregt und die Eigenfrequenzen der Elkos mittels Laservibrometer bestimmt. Der Einsatz eines Laser-Doppler-Vibrometers ist zudem für den vorstehend genannten Ansatz, ohne eine externe eigens nur für das erfindungsgemäße Verfahren genutzte Anregung auszukommen geeignet, denn, insbesondere durch die Empfindlichkeit des Laser-Doppler-Vibrometers kann die Vermessung der Vibrationen während des Funktionstests einer Baugruppe die erfindungsgemäßen genutzten Informationen liefern.

Das erfindungsgemäße Verfahren erlaubt, insbesondere in Verbindung mit einigen, beispielsweise zusätzliche Informationen liefernden Weiterbildungen, dass auch lediglich ein - zu einem ersten Zeitpunkt durchgeführter - Messzeitpunkt genügt, der nach Gebrauch in einer Baugruppe, erfolgt. Dies wird durch die Weiterbildung des erfindungsgemäßen Verfahrens realisiert, bei dem eine Bestimmung des Verlusts des Elektrolyten derart durchgeführt wird, dass die Anregung zu einem ersten Zeitpunkt nach einem dauerhaften Betrieb der Schaltung erfolgt.

Alternativ oder ergänzend, insbesondere wenn ein Vergleich erforderlich ist, kann zu einem zweiten Zeitpunkt, an dem von voller Funktionalität ausgegangen werden kann, beispielsweise nach Fertigung oder Auslieferung, gemessen werden und zusätzliche zum ersten Zeitpunkt erfolgt, wobei zum zweiten Zeitpunkt ein erstes Maß des Elektrolyten bestimmt wird und zum ersten Zeitpunkt ein zweites Maß des Elektrolyten bestimmt wird und wobei auf Grundlage der Differenz zwischen ersten Maß und zweitem Maß eine Restlebensdauerbestimmung durchgeführt wird. Dies wird durch die Weiterbildung des erfindungsgemäßen Verfahrens erreicht, bei dem die Bestimmung des Verlusts des Elektrolyten derart durchgeführt wird, dass die Anregung jeweils zu einem zweiten Zeitpunkt nach Fertigung und zum ersten Zeitpunkt erfolgt, wobei zum zweiten Zeitpunkt ein erstes Maß des Elektrolyten bestimmt wird und zum ersten Zeitpunkt ein zweites Maß des Elektrolyten bestimmt wird und wobei auf Grundlage der Differenz zwischen ersten Maß und zweitem Maß eine Restlebensdauerbestimmung durchgeführt wird.

Vorzugsweise werden die zum ersten Zeitpunkt und/oder zweiten Zeitpunkt bestimmten mechanischen Eigenschaften, Parameter, insbesondere Eigenmoden, insbesondere in einer Datenbank, strukturiert gespeichert, so dass sie zum einen zum Vergleich und zum anderen für eine Optimierung genutzt werden können. Vorstellbar ist auch damit eine künstliche Intelligenz zu trainieren, um beispielsweise die Bewertung und die Vorhersagen auf Grundlage eines mit einem damit trainierten Modell ausgestatteten Moduls und/oder Prozess durchzuführen.

Besonders genau und vorteilhaft könnte es sein, die Bauteile beim Verlassen des Werks zu Vermessen und in einer Datenbank deren Eigenmoden für einen späteren Vergleich abzulegen.

Auch hier bietet sich nach einer Weiterbildung des erfindungsgemäßen Verfahrens, insbesondere die Messmethode mittels Laservibrometer, an, da hier gleich mehrere Elkos einer Baugruppe zeitgleich analysiert werden können. Rückläufer der Baugruppe werden dann bei erneuter Überprüfung auf eine Abweichung von der Werksmessung untersucht.

Auch eine Onlinemessung ist in erfindungsgemäßen Zusammenhang denkbar. Hierdurch könnten Ausfälle im Sinne von Predictive Maintenance vorhergesagt werden und es kann eine Reparatur zu einem günstigen Zeitpunkt veranlasst werden.

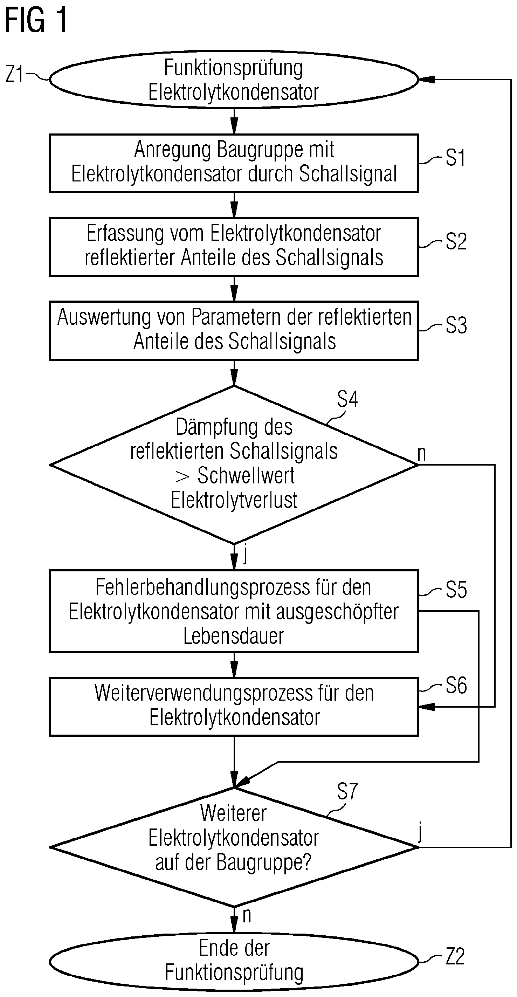

Im Folgenden werden weitere Vorteile und Details der Erfindung sowie Weiterbildungen der Erfindung anhand eines in der einzigen Figur dargestellten Ausführungsbeispiels näher erläutert. Es zeigt die
Figur (FIG 1) schematisch einen beispielhaften Ablauf des Verfahrens.

Bei dem im Folgenden in der Figur FIG 1 erläuterten Ausführungsbeispiel handelt es sich um eine bevorzugte Ausführungsform anhand dessen Vorteile sowie weiteren Ausführungsformen bzw. Weiterbildungen der Erfindung näher erläutert werden.

Insbesondere zeigen die nachfolgenden Erläuterungen lediglich beispielhafte Realisierungsmöglichkeiten, wie insbesondere solche Realisierungen der erfindungsgemäßen Lehre aussehen könnten, da es unmöglich und auch für das Verständnis der Erfindung nicht zielführend oder notwendig ist, all diese Realisierungsmöglichkeiten zu benennen.

Auch sind insbesondere einem (einschlägigen) Fachmann in Kenntnis der unabhängigen Ansprüche alle im Stand der Technik üblichen Möglichkeiten zur Realisierung der Erfindung selbstverständlich bekannt, sodass es insbesondere einer eigenständigen Offenbarung in der Beschreibung nicht bedarf.

Bei dem Ausführungsbeispiel bzw. den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind.

Des Weiteren sind die beschriebenen Ausführungsformen auch durch weitere der bereits beschriebenen Merkmale der Erfindung ergänzbar.

In der einzigen Figur FIG 1 ist nun schematisch als Ausführungsbeispiel des erfindungsgemäßen Verfahrens die Implementierung des erfindungsgemäßen Verfahrens anhand eines Ablaufplans dargestellt. Durch das Ausführungsbeispiel wird einer der Vorteile Erfindung erzielt, der darin besteht den Verlust des Elektrolyten aus einem Elektrolytkondensator festzustellen und bestenfalls gar zu quantifizieren beziehungsweise zu bewerten. Wie anhand des Ablaufplans ersichtlich wird, beruht die durch die Erfindung und somit auch durch das Ausführungsbeispiel realisierte Analysemethode, die diese Vorteile erreicht, auf der Veränderung mechanischer Eigenschaften und hebt sich somit vom Stand der Technik vor allem dadurch ab, dass nicht, wie in der Beschreibungseinleitung angegeben, elektrisch geprüft wird.

Die erfindungsgemäße Analysemethode berücksichtigt auf erfinderische Weise, dass der Anteil des Elektrolyten typischerweise zwischen 5% und 30% der Gesamtmasse des Elektrolytkondensators ausmachen und falls ein Teil des Elektrolyten verloren geht, dies Auswirkungen auf die mechanischen Eigenschaften des Bauteils, wie die Eigenfrequenzen, Moden, Dämpfung bestimmter Frequenzen, Schallgeschwindigkeit des Bauteils hat.

Das erfindungsgemäße Ausführungsbeispiel startet daher aus einem ersten Zustand Z1 "Funktionsprüfung Elektrolytkondensator" einer das erfindungsgemäße Verfahren implementierenden Anordnung in einem ersten Schritt S1 des Verfahrens gemäß Ausführungsbeispiel der Erfindung mit einer Anregung einer Baugruppe, welche mindestens einen Elektrolytkondensator enthält durch mindestens ein Schallsignal, um damit eine erfindungsgemäße Messung einzuleiten, die eine oder mehrere dieser mechanischen Eigenschaften betrifft.

Hierzu wird in einem zweiten Schritt S2 mindestens ein reflektierter Anteil des Schallsignals erfasst. Aufgrund dieser Erfassung sind Werte der mechanischen Eigenschaften bzw. wenn, wie gemäß einer Weiterbildung der Erfindung denkbar, insbesondere initiale, Vergleichswerte vorhanden sind, Veränderungen messbar. Dabei können gemäß einer Weiterbildung der erfindungsgemäßen Anordnung die Messungen bzw. Veränderungen grundsätzlich mit Verfahren der Ultraschallprüfung, wie sie in der klassischen Materialprüfung eingesetzt werden, ermittelt werden. Bei dem Ausführungsbeispiel erfolgt die Anregung also mit einem oder mehreren Schallsignalen, deren Frequenzen im Ultraschallbereich liegen.

Gemäß einer weiteren Weiterbildung kann dies grundsätzlich mittels einer so genannten Durchschallung erfolgen, welche allerdings getrennte Sender- und Empfänger-Prüfköpfe benötigt. Daher kann gemäß einer vorteilhaften Weiterbildung der ersten beiden Schritte S1...S2 das Impuls-Echo-Verfahren besonders vorteilhaft sein. Denn neben weiteren Vorteilen, weist dieser Ansatz den Vorteil auf, dass Sender und Empfänger hier in einem Prüfkopf vereint sind oder sich desselben Piezoelements bedienen.

In einem dritten Schritt S3 wird nun der erfasste reflektierte Anteil des Schallsignals dahingehend ausgewertet, ob ein Verlust vorliegt, was gemäß dem dargestellten Ausführungsbeispiel durch Feststellung der Dämpfung des Schallsignals anhand von damit zumindest korrelierenden Charakteristiken, insbesondere Amplitude und/oder Phase, des erfassten Anteils erfolgt.

Dies ist vorteilhaft, da erfindungsgemäß berücksichtigt wird, dass bei Verlust des Elektrolyten davon auszugehen ist, dass sich über die Zeit, die der Elektrolytkondensator eingesetzt ist, beispielswiese die Laufzeit und Dämpfung des reflektierten Anteils des Schallsignals sich ändert. Mit den bisherigen Schritten S1...S3 ist dies feststellbar.

Vorteilhaft ist dabei gemäß einer Weiterbildung die Ultraschallanregung in Nähe einer Eigenresonanzfrequenz der Elektrolytkondensatoren durchzuführen, also die Frequenz des Schallsignals so einzustellen, da in diesem Fall große Änderungen von Amplitude und Phase zu erwarten sind und die Erfassung leichter und die Auswertung akkurater erfolgt.

Gemäß einer weiteren Weiterbildung kann die Einstrahlung, also Anregung durch mindestens ein Schallsignal, mit einer großen Bandbreite durchgeführt werden. Also mit einer Vielzahl von Schallsignalen. Dies führt zu einer Anregung mehrerer Eigenresonanzen bzw. die Bandbreite kann so eingestellt sein, dass mehrere Schallsignale in der Nähe disjunkter Eigenresonanzen zu liegen kommen. Die erfassten reflektieren Anteile der Schallsignale führen daher zu einem größeren Satz von Daten mit einer Vielzahl erfasster Charakteristiken, die in Summe also genauere Bestimmungen des Verlustes von Elektrolyten möglich machen.

Beispielsweise ermöglicht der relative Vergleich der reflektierten Amplituden unterschiedlicher Frequenzen (Eigenfrequenzen) eine Nutzung als Alterungsindikator, der weitgehend unabhängig von geometrischen Randbedingungen ist.

Unter Umständen ist hierbei auch keine Kenntnis darüber nötig, welchen Wert die Dämpfung im Zustand nach Fertigung der Baugruppe hatte, sondern kann beispielsweise allein aufgrund der sich ergebenden relativen Vergleiche untereinander einen spezifischen Elektrolytwert indizieren.

Auch kann gemäß vorteilhafter Weiterbildung durch die Festlegung auf eine oder mehrere spezifische Frequenzen des Schallsignals der Rückschluss auf die Elektrolytmenge getroffen werden.

Beispielsweise kann nach einer Weiterbildung vorgesehen sein, feste Frequenzen, welche direkt auf die Detektion von Feuchtigkeit (oder deren Abwesenheit) abzielen, einzusetzen. Insbesondere im kHz-Bereich gewählte Frequenzen sind nach einer weiteren Weiterbildung diesbezüglich vorteilhaft geeignet. Nach einer anderen Weiterbildung können auch feste Ultraschallfrequenzen im MHz Bereich hierzu von Vorteil sein. Auch ein so genannter Frequenzsweep, also ein Ansatz bei dem im Gegensatz zu den für einzelne Schallsignale fest eingestellten Frequenzen mehrere Schallsignale über einen Frequenzenbereich nacheinander eingestellt und abgestrahlt werden, ist als Weiterbildung möglich.

Die Erfindung lässt es aber auch gemäß einer Weiterbildung zu, dass die Charakteristika der reflektierten Anteile nicht untereinander, sondern mit bekannten Ausgangswerten, die zum jeweiligen Elektrolytkondensator gehören, in Bezug gesetzt werden, wie beispielsweise gemäß dem dargestellten Ausführungsbeispiel, bei dem in einem vierten Schritt S4 ermittelt wird, ob die ermittelte Dämpfung einen Schwellwert überschreitet, der beispielsweise ein Prozentsatz des bei der Herstellung des Elektrolytkondensators bekannten Elektrolytmenge und/oder bei bzw. nach dem Verbauen in der Baugruppe vorhandenen Elektrolytmenge darstellt, der auf einen auszusortierenden Elektrolytkondensator hinweist, so dass die Baugruppe nicht oder nicht in dieser Zusammensetzung recycelt werden kann.
Ist das der Fall, wird in einem fünften Schritt S5 ein Fehlerbehandlungsprozess angestoßen, bei dem insbesondere eine Ausgabe initiiert wird, dass der Elektrolytkondensator seine Lebensdauer so weit ausgeschöpft hat, dass eine Weiterverwendung keinen Sinn macht.

Andernfalls wird in einem sechsten Schritte S6 ein Weiterverwendungsprozess getriggert, bei dem insbesondere eine Ausgabe initiiert wird, dass der Elektrolytkondensator weiterverwendbar ist.

Wie zu erkennen ist, wird gemäß Ausführungsbeispiel des erfindungsgemäßen Verfahrens eine Baugruppe mit mindestens einem Elektrolytkondensator geprüft. Daher wird nach den fünften Schritt S5 oder dem sechsten Schritt S6 in einem siebten Schritt S7 geprüft, ob weitere ungeprüfte Elektrolytkondensatoren auf der Baugruppe enthalten sind, so dass beispielsweise die Anregung entsprechend auf den weiteren Kondensator ausgerichtet erneut durchgeführt werden kann. Bei einer alternativen oder ergänzenden Weiterbildung kann es vorgesehen sein, dass hierzu die durch die Anregung im ersten Schritt S1 reflektierten Anteile eines weiteren Elektrolytkondensators untersucht werden. Es bedarf also unter Umständen keiner weiteren Anregung. Dies wird insbesondere in Verbindung mit einer gleichzeitigen, insbesondere der im Rahmen dieser Offenbarung hierfür als geeignet genannten, Anregung mehrerer Elektrolytkondensatoren vorteilhaft sein.

Ergibt der siebte Schritt S7 das noch ein ungeprüfter Elektrolytkondensator vorhanden ist, wird gemäß dem Ausführungsbeispiel vom ersten Zustand Z1 ausgehend die Prüfung mit dem weiteren Elektrolytkondensator wiederholt.

Sind alle Elektrolytkondensatoren geprüft worden, ergibt also die Überprüfung im siebten Schritt S7, dass es keine weiteren ungeprüften Elektrolytkondensatoren gibt, wechselt das Verfahren gemäß Ausführungsbeispiel in einen zweiten Zustand Z2 der erfindungsgemäßen Anordnung "Ende der Funktionsprüfung".

Gemäß einer Weiterbildung der Erfindung kann mit dem Vorteil einer schnellen Vermessung ganzer Gruppen von Elektrolytkondensatoren nach der Fertigung des Kondensators und/oder nach Fertigung der Baugruppe der Einsatz eines Laservibrometers (Laser-Doppler-Vibrometer) vorteilhaft sein, bei dem eine Gruppe von Elektrolytkondensatoren erfindungsgemäß extern angeregt und die Eigenfrequenzen der Elektrolytkondensatoren mittels Laservibrometer bestimmt wird. Denkbar ist auch eine Weiterbildung bei dem kein zusätzlicher externer Anreger, der vorsätzlich Schwingungen erzeugt, eingesetzt wird, sondern bei der die Vermessung der Vibrationen während des Funktionstests einer Baugruppe, der die Vibrationen verursacht und als externer Anreger betrachtet wird, die erfindungsgemäß nötigen physikalischen Reaktionen und damit Informationen triggert.

Gemäß einer Weiterbildung der Erfindung ist die Speicherung solcher initialen Vermessung für den späteren Vergleich vorgesehen. Beispielsweise ist es besonders genau und vorteilhaft, die Bauteile beim Verlassen des Werks zu vermessen und in einer Datenbank deren mechanische Eigenschaften, wie beispielsweise die Eigenmoden, abzulegen, wobei sich hierzu, wie vorstehend angegeben, sich ebenfalls insbesondere die Messmethode mittels Laservibrometer anbietet, da hier gleich mehrere Elektrolytkondensatoren einer Baugruppe zugleich analysiert und, Rückläufer zu einem späteren Zeitpunkterneut überprüft werden, so dass eine Abweichung von der Werksmessung festgestellt werden kann

Gemäß einer weiteren Weiterbildung der Erfindung ist es auch denkbar, mittels einer eingebauten Vorrichtung zur Messung der Schwingungseigenschaften den Zustand der Elektrolytkondensatoren auf die erfindungsgemäße Weise, die mechanischen Eigenschaften zu prüfen, kontinuierlich erfasst werden. Dies kann dann abgelegt werden, um bei regelmäßigen Wartungen ausgelesen zu werden und/oder laufend bewertet und, beispielweise als Warnung vor dem baldigen Ende der Lebensdauer, ausgegeben werden.

Bestenfalls kann mit der Erfindung also der Verlust des Elektrolyten bereits festgestellt, bevor er elektrisch feststellbar ist und so eine Vorhersage zur Restlebensdauer vor dem Auftritt von Ausfällen gemacht werden.

Die Erfindung ist also eine weitere Messmethode zur Detektion defekter Elektrolytkondensatoren für die eine elektrische Kontaktierung nicht notwendig ist, was zu vielfältigen, unter anderem den oben genannten, Vorteilen führt.

*Unabhängig vom grammatikalischen Geschlecht eines bestimmten Begriffes sind Personen mit männlicher, weiblicher oder anderer Geschlechteridentität mit umfasst.*

## Patentansprüche

1. Verfahren zur Funktionsprüfung einer mindestens eines, insbesondere in einer elektronischen Schaltung angeordneten, Elektrolytkatalysators, **dadurch gekennzeichnet, dass** zu zumindest einem ersten Zeitpunkt auf Grundlage zumindest eines externen Anregungssignals erzeugte mechanische Anregung des Elektrolytkondensators zumindest eine, insbesondere Veränderung einer, mechanischen, mit dem Maß, insbesondere des Verlusts, des Elektrolyten korrelierenden, Eigenschaft des Elektrolytkondensators ermittelt wird.

2. Verfahren nach dem vorhergehenden Anspruch, **dadurch gekennzeichnet, dass** als externes Anregungssignal zumindest eine durch eine externe Ultraschallquelle erzeugte Schallwelle der Elektrolytkondensator zur Schwingung angeregt wird und zumindest vom Elektrolytkondensator reflektierte Anteile der Schallwelle korrelierende Parameter, insbesondere Eigenfrequenzen, Moden, Dämpfung zumindest einer Frequenz der reflektierten Anteile und/oder Schallgeschwindigkeit, derart erfasst werden, dass in Abhängigkeit der Parameter der Grad des Verlusts des Elektrolyten bestimmt wird.

3. Verfahren nach dem vorhergehenden Anspruch, **dadurch gekennzeichnet, dass** die Ultraschallquelle im so genannten Durchschallverfahren betrieben wird.

4. Verfahren nach einem der Ansprüche 1 bis 2, **dadurch gekennzeichnet, dass** die Ultraschallquelle im so genannten Impuls-Echo Verfahren betrieben wird.

5. Verfahren nach einem der vorhergehenden Ansprüche, **dadurch gekennzeichnet, dass** die zumindest eine Schallwelle derart erzeugt wird, dass ihre Frequenz in einem Bereich nahe der Eigenresonanzfrequenz des Elektrolytkondensators eingestellt wird, wobei als Parameter zumindest der Wert der Amplitude und/oder der Wert der Phase des reflektierten Anteils der Schwingung erfasst wird.

6. Verfahren nach einem der Ansprüche 2 bis 5, **dadurch gekennzeichnet, dass** eine Vielzahl an Schallwellen unterschiedlicher Frequenzen derart erzeugt werden, dass zumindest jeweils eine Frequenz der unterschiedlichen Frequenzen nahe jeweils einer Eigenresonanzfrequenz aus einer Vielzahl von Eigenfrequenzen derart eingestellt wird, dass zu jeder Eigenresonanzfrequenz der Vielzahl von Eigenresonanzfrequenzen zumindest eine Frequenz erzeugt wird.

7. Verfahren nach dem vorhergehenden Anspruch, **dadurch gekennzeichnet, dass** für jede Frequenz die Parameter der reflektierten Anteile erfasst werden, wobei das Maß, insbesondere des Verlusts, des Elektrolyten anhand eines Vergleichs der Parameter je Frequenz ermittelt wird.

8. Verfahren nach dem vorhergehenden Anspruch, **dadurch gekennzeichnet, dass** eine diskrete Anzahl von, insbesondere im kHz-Bereich eingestellten, Frequenzen innerhalb der Bandbreite festgelegt wird.

9. Verfahren nach dem Anspruch 6, **dadurch gekennzeichnet, dass** die Frequenzen innerhalb der Bandbreite derart eingestellt werden, dass sie innerhalb einer Zeitspanne ein durch Bandbreite bestimmtes Intervall von, insbesondere im MHz-Bereich eingestellten, Frequenzen durchlaufen.

10. Verfahren nach einem der vorhergehenden Ansprüche, **dadurch gekennzeichnet, dass** für die Ermittlung der mechanischen Eigenschaft des Elektrolytkondensators, insbesondere die Erfassung der Parameter der reflektierten Anteile, ein Laser-Doppler-Vibrometer betrieben wird.

11. Verfahren nach einem der vorhergehenden Ansprüche, **dadurch gekennzeichnet, dass** eine Bestimmung des Verlusts des Elektrolyten derart durchgeführt wird, dass die Anregung zu einem ersten Zeitpunkt nach einem dauerhaften Betrieb der Schaltung erfolgt.

12. Verfahren nach dem vorhergehenden Anspruch, **dadurch gekennzeichnet, dass** die Bestimmung des Verlusts des Elektrolyten derart durchgeführt wird, dass die Anregung jeweils zu einem zweiten Zeitpunkt nach Fertigung und zum ersten Zeitpunkt erfolgt, wobei zum zweiten Zeitpunkt ein erstes Maß des Elektrolyten bestimmt wird und zum ersten Zeitpunkt ein zweites Maß des Elektrolyten bestimmt wird und wobei auf Grundlage der Differenz zwischen ersten Maß und zweitem Maß eine Restlebensdauerbestimmung durchgeführt wird.

13. Verfahren nach dem vorhergehenden Anspruch, **dadurch gekennzeichnet, dass** das die zum ersten Zeitpunkt und/oder zweiten Zeitpunkt bestimmten mechanischen Eigenschaften, Parameter, insbesondere Eigenmoden, insbesondere in einer Datenbank, strukturiert gespeichert werden.

14. Anordnung zur Funktionsprüfung einer mindestens eines, insbesondere in einer elektronischen Schaltung angeordneten, Elektrolytkatalysators, **gekennzeichnet durch**, Mittel zur Durchführung des Verfahrens nach einem der vorhergehenden Ansprüche.
